# EUROPEAN PATENT SPECIFICATION

(11) **EP 0 995 086 B1**
(45) Date of publication and mention of the grant of the patent: **14.11.2007**
(21) Application number: 99920970.3
(22) Date of filing: 05.05.1999
(51) Int. Cl.: G01J 3/44, H01J 37/26

(54) **ELECTRON MICROSCOPE AND SPECTROSCOPY SYSTEM**
ELEKTRONENMIKROSKOP UND SPEKTROSKOPISCHES SYSTEM
MICROSCOPE ELECTRONIQUE ET SYSTEME DE SPECTROSCOPIE

(30) Priority: 09.05.1998 GB 9809835; 09.05.1998 GB 9809834
(43) Date of publication of application: 26.04.2000
(73) Proprietor: Renishaw plc, Wotton-Under-Edge Gloucestershire GL12 8JR (GB)
(72) Inventor: DAY, John C.C. Univ. of Bristol, Interface Analysis Centre, Bristol BS2 8BS (GB); BENNETT, Robert, Gloucestershire GL10 3TT (GB)
(74) Representative: Jackson, John Timothy
(86) International application number: PCT/GB1999/001395
(87) International publication number: WO 1999/058939

(56) References cited:
- EP-A- 0 184 792
- WO-A-95/32408
- FR-A- 2 399 660
- FR-A- 2 596 863
- GB-A- 2 079 486

## Description

### Field of the Invention

This invention relates to sample analysis systems. In a preferred embodiment, for example, an electron microscope is combined with a spectroscopy system, e.g. a Raman or photoluminescence or cathodoluminescence spectroscopy system.

### Background and Summary of the Invention

Such combined systems have previously been disclosed in French patent specification no. FR 2596863 and International patent specification no. WO 95/20242.

In FR 2596863, a plane mirror is placed in an electron microscope, at 45° to its axis. For Raman spectroscopy, an illuminating laser beam passes through a window in the electron microscope housing. The 45° mirror reflects the laser beam towards a sample, along the axis of the electron microscope. The beam is focussed to a spot on the sample by a Cassegrain objective. Raman scattered light is collected by the Cassegrain objective and reflected by the mirror through the window to a spectrometer. For electron microscopy, the electron beam irradiates the sample through central apertures in the 45° mirror and the Cassegrain objective. Simultaneous examination of the sample by both electron microscopy and Raman spectroscopy is therefore possible, and the Cassegrain objective has a wide collection angle for efficient collection of the very weak Raman scattered light. However, in practice it is difficult to mount both this objective and the 45° mirror in the restricted space available in the sample chamber of a commercial electron microscope. FR 2596863 therefore mounts them within the electron lens system.

WO 95/20242 points out various problems of that arrangement. It proposes to overcome these problems by mounting the sample on a displaceable mount. The optical system for the Raman spectroscopy is not co-axial with the electron microscope, and the sample is moved on its mount from one to the other. However, this makes simultaneous examination by the Raman and electron microscope systems impossible. It also requires the mount to be an expensive precision stage in order to move the sample precisely between the respective analysis points of the electron system and the optical system.

A book "Raman Microscopy: Developments and Applications", edited by George Turrell et al, Academic Press Limited, 1996, Chapter 5, pages 201-220, suggests on pages 215-216 that a parabolic mirror can be used in place of a Cassegrain objective and 45° plane mirror. This is mechanically simpler, and can be mounted within the sample chamber of the electron microscope. For Raman spectroscopy, laser light is injected transversely to the axis of the electron beam. The parabolic mirror reflects it through 90°, coaxial with the electron beam, and focuses it to a spot on the sample. The electron beam again passes through a central aperture in the parabolic mirror. The parabolic mirror collects Raman and other scattered light from its focal point, and passes it back along the transverse path out of the sample chamber of the electron microscope.

However, when such a mirror is not in use, it tends to hinder other analytical techniques, such as x-ray spectrometry of the x-rays produced by the electron bombardment of the sample. Furthermore, when the mirror is placed in the sample chamber it must be correctly aligned. Not only must the central aperture be aligned with the electron beam, but also the optical focus of the mirror must be relocated at the same point on the sample, relative to the electron beam.

European patent application EP 0184792 discloses means of recording images of a sample in an electron microscope. In use, an electron beam passes through the sample and forms a magnified transmission image which is projected onto a two-dimensional image sensor, comprising a stimulable phosphor sheet. The stimulable phosphor sheet stores the energy of the electron beam which carries the magnified transmission image. A stimulating laser beam is used to scan the phosphor sheet in two dimensions. The stimulable phosphor sheet emits light in an intensity commensurate with the energy level of the electron beam which was applied to the sheet. Light emitted from the sheet is photo-electrically detected by a photomultiplier and generates an electrical signal which is fed to an image reproducer or image recording apparatus. A movable mirror is provided which when in its operable position is in the path of the electron beam and directs the stimulating laser beam to the sample and which may be retracted out of the path of the election beam to allow the stimulable phosphor sheet to be exposed to the electron beam.

One aspect of the present invention provides an adapter for performing an optical analysis (e.g. by spectroscopy) of a sample mounted in a sample chamber of another analytical apparatus (such as an electron microscope), said analytical apparatus having an analytical axis and projecting an analysis beam generally along said analytical axis towards a sample, the adapter comprising all the features recited in claim 1.

Preferably, an optical system is provided for processing the input light beam and the scattered light, said optical system being movable together with the mirror as the mirror moves between the operative and inoperative positions. Preferably the optical system includes one or more filters for rejecting light having the wavelength of the input light beam from said scattered light.

Preferably the concave mirror is a paraboloid mirror, in order to focus a spot (which can be diffraction limited) onto the sample from a collimated input light beam, and in order to produce a collimated output light beam of said scattered light collected from said spot. The optical system may output the scattered plight to a spectroscopy system, to analyse the spectrum of the scattered light collected from the spot.

A spectroscopy system is known from European Patent Application No. EP 543578, in which exciting laser light is injected into an optical path and directed towards a sample by a dichroic filter. The dichroic filter is preferably a holographic filter at a low angle of incidence, e.g. 10° to the optical path. Light which is epi-scattered from the sample returns back along the optical path to the dichroic filter. Desired inelastically scattered light (e.g. Raman) passes through the filter to a spectrometer system, while undesired elastically scattered (Rayleigh) light is rejected by the filter.

The filter in such an arrangement must be designed to reflect the wavelength of the laser used. This ensures that it can reflect the incoming laser light towards the sample, and can reject the elastically scattered light having the same wavelength as the laser.

It is often desirable to be able to change the laser, in order to use a different excitation wavelength. With the arrangement of EP 543578, this means that the filter must also be changed to match the new wavelength. Unless special measures are provided for accurate positioning of the filters, this can entail an awkward and time-consuming job of realigning the system with the new filter.

### Brief Description of the Drawings

Combined electron microscopy and spectroscopy systems which exemplify the invention will now be described, with reference to the accompanying drawings in which:
Fig 1 is a schematic representation of the combined systems, an adapter between the systems being shown in cross-section;
Fig 2 is a schematic diagram of an optical system;
Fig 3 and Fig 4 are alternative schematic layouts of light injection and rejection systems for use with the system of Fig 2.

### Description of Preferred Embodiments

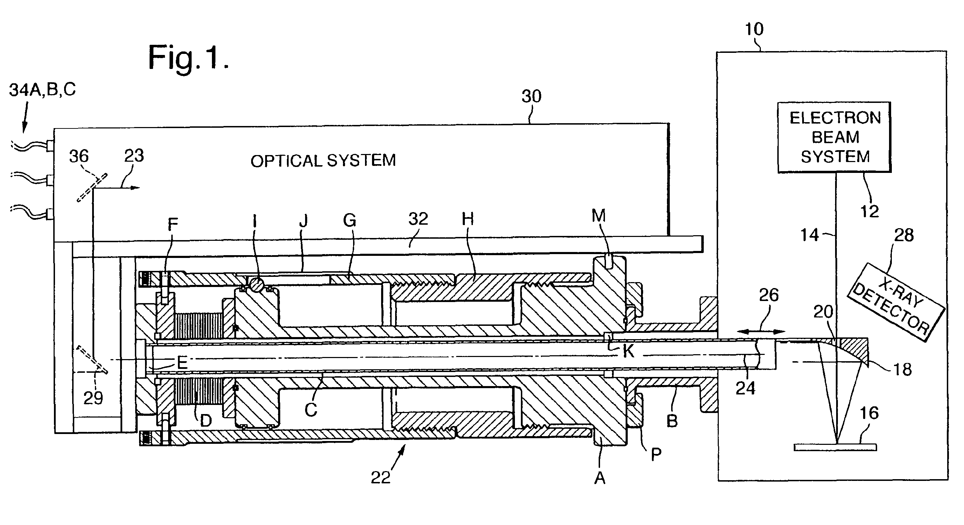

Fig 1 shows a scanning electron microscope (SEM) 10 with a conventional electron beam generation, focusing and scanning system 12. This projects a beam of electrons generally along an analytical axis 14 to a sample 16, in a well known manner.

In place of a scanning electron microscope, the invention may also be used with other types of analytical system, including transmission electron microscopes, and also with apparatus such as ion beam bombardment systems.

A parabolic or other concave mirror 18 is mounted generally on the axis 14 above the sample 16, and has a central aperture 20 so that the electron beam may pass through. The parabolic mirror 18 is mounted on a mirror holder arm assembly 22, described below, having an optical axis 24 which is generally transverse to the analytical axis 14 of the SEM. The mirror holder 22 is able to retract the parabolic mirror 18 as shown by double-headed arrow 26, between an operative position (as shown) and an inoperative position (retracted away from the analytical axis 14). Thus, when in the inoperative position, the parabolic mirror 18 does not interfere with other equipment within the scanning electron microscope, such as an x-ray detector 28 which can be used to detect x-rays generated by the bombardment of the sample 16 with the electron beam.

An optical system 30 is mounted on an optical bench 32, which is in turn mounted on the mirror holder arm assembly 22. As described in more detail below, the mirror holder 22 moves the optical system 30 together with the parabolic mirror 18, in order to maintain alignment between the two. The optical system 30 includes input and output optical fibre connections 34A,B,C. These receive an input from a laser, and take one or more outputs to an external spectrometer, such as a Renishaw Mk III Raman Spectrometer.

Further details of the optical system 30 are described later.

The optical system directs the input laser beam via 45° mirrors 36,29 along the optical axis 24 of the mirror holder arm assembly 22 to the parabolic mirror 18, which focuses it to a (preferably diffraction-limited) spot on the sample 16. The parabolic mirror 18 also collects scattered light from this spot, collimates it and feeds it back in the return direction along the optical axis 24 to the optical system 30. For example, there may be inelastically scattered light such as Raman scattering, or fluorescence or photoluminescence. It will also include elastically scattered (Rayleigh) light at the laser wavelength. Alternatively, or additionally, the light collected from the sample 16 by the mirror 18 may be cathodoluminescence, generated by the action of the electron beam on the sample without the need for a laser input. It will be appreciated that the study of the inelastically scattered light may be performed simultaneously with the electron microscopy, or immediately before or after the electron microscopy, without the need to change the set up. It is therefore easy to correlate the results of the electron microscopy with the results of the spectroscopy.

The mirror holder must have the ability to move the parabolic mirror within the vacuum of the scanning microscope to a sensitivity of 0.1mm. This tolerance is set by the requirement that the 1mm aperture running vertically through the mirror is aligned on the axis of the electron optics with an unrestricted line of sight between the electron microscope objective and the sample positioned at the focal point of the parabola. Perpendicular to the axis 24 of the mirror holder arm the total movement of the parabola need only be a few millimetres, sufficient to compensate for manufacturing and assembly tolerances in the complete system. Along the axis of the arm the movement must be at least 50mm so that the parabola may be retracted clear of the sample area of the microscope. This movement must be performed without affecting the vacuum of the SEM. In addition, this movement should not disturb the very critical optical alignment between the parabola and the laser source. The latter is the reason why the arm is mounted rigidly with respect to the optical base 32 which therefore must move with the arm as it is adjusted. We have found it difficult merely to rely on the fact that the laser beam is collimated between the optical system and the parabolic mirror; any minute misalignment between the axis of the beam and the axis of the parabola would mean that the focus must be readjusted after each retraction of the mirror.

Two methods can be used for creating a vacuum seal capable of linear movement. One is a sliding O-ring arrangement. However, we prefer a bellows arrangement. Bellows are a much more reliable form of seal and are suitable for much lower pressures, they also allow tilt and a slight lateral movement. O-ring seals are cheaper to make but do not allow any tilt and are prone to degradation with use. In the preferred embodiment it was decided to use edge welded bellows, rather than the cheaper hydroformed bellows, because this gives greater extension.

Various means of driving the extension are possible, including linear bearing tracks and screw drives, however the simplest and cheapest solution was deemed to be a simple screwed collar arrangement which imparts both rigidity and sensitivity with a minimum of weight and components.

As shown in Fig 1, the arm assembly 22 consists of a main body piece A that is attached to the microscope via a transition piece B. The transition piece will be designed to suit whichever make or model of microscope is required and allows the body to become a standard item. The transition piece and body are joined by O-ring seals compressed at the body side by a separate split clamp P. This clamp allows the body to be rotated to provide rotational alignment.

The tubular optical arm C which supports the parabolic mirror 18 is attached to the body by the edge welded bellows D. An O-ring sealed optical flat E retained by a threaded ring provides the vacuum window for light extraction.

The junction of the bellows and vacuum arm is supported by two orthogonal sets of opposing threaded pins at F. Adjustment of these pins moves the end of the optical arm with respect to the microscope and consequently moves the parabola within the microscope. These pins are located in a cylinder G which is slidably mounted on the body A. The cylinder G is threaded with a left-hand thread at the opposite end. This cylinder is screwed onto the adjusting collar H that is in turn screwed via a right hand thread to the main body A. Rotating this adjusting collar causes the cylinder G to slide in or out from the body and so effects the translational motion of the parabola into the microscope.

When the adjusting collar is turned a torque will be applied to the bellows and optical arm. Although the bellows will prevent the arm from rotating it was felt prudent to incorporate 3 locating pegs at I that are fixed to the main body and run in slots in the cylinder. These prevent any loading being applied to the bellows. A cosmetic cylindrical cover J covers the slots and pegs. The end of the main body A has two O-rings around its circumference which bear onto the cylinder to provide further support and location.

In order to control the tilting of the arm caused by the orthogonal adjusters at F, a PTFE ring is fixed in the main body at K and bears on the optical arm that runs through its centre. This ring defines the pivot point about which the arm moves when tilted.

The optical bench assembly 32 onto which all optics are mounted is bolted to the end of the mirror arm C and is fixed in relation to the parabolic reflector. When the arm is tilted, the bench therefore moves with respect to the microscope but not the parabola. To reduce the torque on the microscope and to minimise size, the bench returns along the length of the arm and is supported by a single bearing at M, in the form of a sprung ball. This bearing is positioned on the same vertical axis as the PTFE ring at K and so defines an axis about which horizontal tilts take place. Ideally we would provide more support for the optical bench at the microscope end but this was not possible without constraining the tilt. The 45° mirror 29 steers light from the parabolic mirror to the level of the optical bench. The further mirror 36 deflects the light onto the bench.

The bellows are made from stainless steel. All other parts are aluminium except the arm C which is also stainless steel for rigidity and ease of fabrication. The edge welded bellows has standard knife edge seals on the flanges at each end. Reusable, viton seals are used in these flanges rather than copper gaskets.

The sensitivity of adjustments is determined by the pitch of the screw threads on the adjusters at F. The threaded collar G has 2.5mm pitch on both ends giving 5mm of lateral movement per rotation or 14µm per degree. The adjusters at F are 0.5mm pitch giving about 1.4µm per degree movement at the collar. This will translate to a similar sensitivity at the parabola although the exact amount will depend on the length of the arm and its degree of extension.

It was mentioned above that the optical system 30 moves in and out with the mirror 18, to preserve the alignment. If it is desired to use a fixed optical system, the arm assembly 22 could be arranged to bias the optical arm C into a kinematic support in the operative position.

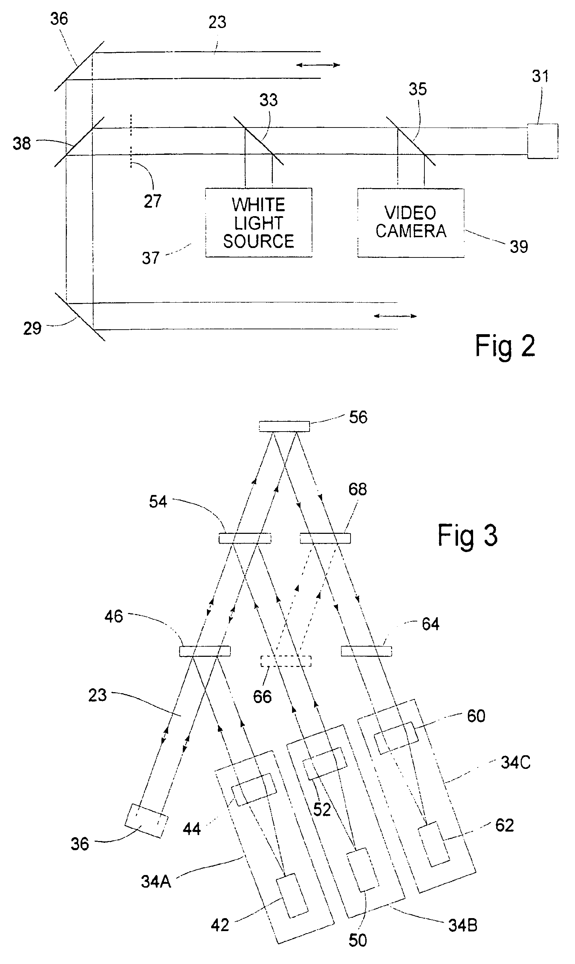

Fig 2 shows the mirrors 29,36 in the optical path 23 between the arm assembly 22 and the optical system 30 on the bench 32. In addition, mounted on the bench is a retractable mirror 38 which can be placed in the optical path. Where cathodoluminescence is produced by the electron bombardment of the sample, this can be detected by inserting the mirror 38 to direct the cathodoluminescence towards an optical fibre connector 31, also on the bench. This includes a focusing lens for focusing the light onto a large aperture optical fibre. The use of a large aperture fibre permits the receipt of cathodoluminescence from a wide field of view on the sample 16, not merely from the focal point of the parabolic mirror 18. Typically, a 6mm focusing lens and a 100µm fibre may be used to give a 100µm field of view at the sample. Thus, the electron beam can be scanned over that field of view and all the resulting cathodoluminescence collected.

The cathodoluminescence output from the optical fibre connector 31 is taken to a suitable detector arrangement. This may comprise a tunable filter for selecting a desired wavelength of cathodoluminescence, followed by a photomultiplier or avalanche photodiode. The output of the photomultiplier or avalanche photodiode is taken to a computer, which produces a two-dimensional map of the cathodoluminescence in a conventional manner, by processing the output in real time in synchronism with the scanning of the electron beam system 12 of the scanning electron microscope.

If desired, beamsplitters 33,35 may also be placed between the mirror 38 and the fibre connector 31. The mirror 33 permits injection of white light from a source 37, to illuminate the sample 16. The sample may then be viewed by a video camera 39, e.g. a CCD camera, via the beamsplitter 35, in order to assist setting up the sample and correlation of features found by the electron microscope and/or spectroscopy systems.

When the sample is illuminated by the white light source 37, a stop 27 may be provided in the beam path (e.g. an adjustable iris). This reduces the beam diameter in order to reduce spherical aberrations caused by the parabolic mirror 18.

The retractable mirror 38 may if desired be replaced by a beamsplitter permanently located in the optical path. However, this has the disadvantage that some of the inelastically scattered light is lost in the beamsplitter and does not pass back along the optical path 23.

The arrangements for injection of laser light and rejection of Rayleigh scattered light will now be described.

Fig 3 shows a plan view of the optical path 23, shown in elevation in Figs 1 and 2. Laser light at a first, lower wavelength, such as blue or green, e.g. 514nm is injected through an optical fibre via the fibre connector 34A of Fig 1. This comprises a mount 42 for the optical fibre and a collimating lens 44. This is directed at a holographic notch filter 46, located in the optical path 23 at a low angle of incidence such as 10°. The holographic notch filter 46 is designed to reflect the input laser beam at 514nm. This then passes along the optical path 23 to the electron microscope shown in Fig 1.

Similarly, for excitation at a longer wavelength, e.g. red or infra-red light at 785nm, there is provided the fibre connector 34B, comprising a fibre mount 50 for an optical fibre delivering the red or infra-red laser light, and a collimating lens 52. The red or infra-red laser light is directed to a holographic notch filter 54 in the optical path 23. This is configured in the same way as the holographic notch filter 46, except that its notch is designed to reflect the incoming light at 785nm.

The system can be used in various modes, as follows.

For examining a sample such as, say, a semiconductor, a 514nm laser can be connected up to the connector 34A, in order to illuminate the sample 16. Raman scattered light on the Stokes side of the laser line is then passed back via the optical path 23, and passes straight through the filter 46. This filter rejects Rayleigh scattered light having the wavelength 514nm. The Stokes Raman scattered light (up to about 5000cm⁻¹) will then pass straight through the filter 54 undisturbed, because the 785nm notch in this filter lies beyond 5000cm⁻¹. It is then reflected by a mirror 56 towards the third fibre connector 34C, again comprising a focusing lens 60 and fibre mount 62. On the way, it may optionally pass through a further holographic notch filter 64, designed to reject more of the Rayleigh scattered light at 514nm.

The light output from the fibre connector 34C is taken via an optical fibre to an appropriate spectrometer for analysis, e.g. a Renishaw Mk III Raman Spectrometer.

If it is desired to analyse inelastically scattered light such as photoluminescence which extends beyond 5000cm⁻¹ from the laser line, then it will be appreciated that some of this light will be rejected from the optical path by the 785nm notch filter 54. This light is recovered as follows. A movable mirror 66 is moved in between the filter 54 and the optical fibre connector 34B, and receives the desired light which has been rejected from the optical path 23 by the filter 54. It reflects it to a further holographic notch filter 68, designed to reflect light at 785nm but pass all other light. This further holographic notch filter 68 recombines the light rejected by the filter 54 with the rest of the light passing from the mirror 56 towards the fibre connector 34C. Thus, the full range of wavelengths of photoluminescence is passed to the spectrometer for study.

Another mode of operation is as follows. This is suitable for, say, organic and biological materials, polymers, photo resist etc.

Many such materials have the problem that any Raman scattered light can be masked by fluorescence. This is overcome by using a longer excitation wavelength, e.g. 785nm, injected by an optical fibre connected to the fibre connector 34B (with the mirror 66 moved out of the way). This excitation light is reflected by the holographic notch filter 54 and passes straight through the filter 46 along the optical path 22 towards the sample 14. Returning Raman scattered light again passes unaffected through the filter 46. It is transmitted by the filter 54, which rejects the Rayleigh scattered light at 785nm. The Raman scattered light is reflected by the mirror 56, and passes through the second 785nm holographic notch filter 68 which performs further Rayleigh rejection. It is then taken to the spectrometer as before, via the optical fibre connector 34C.

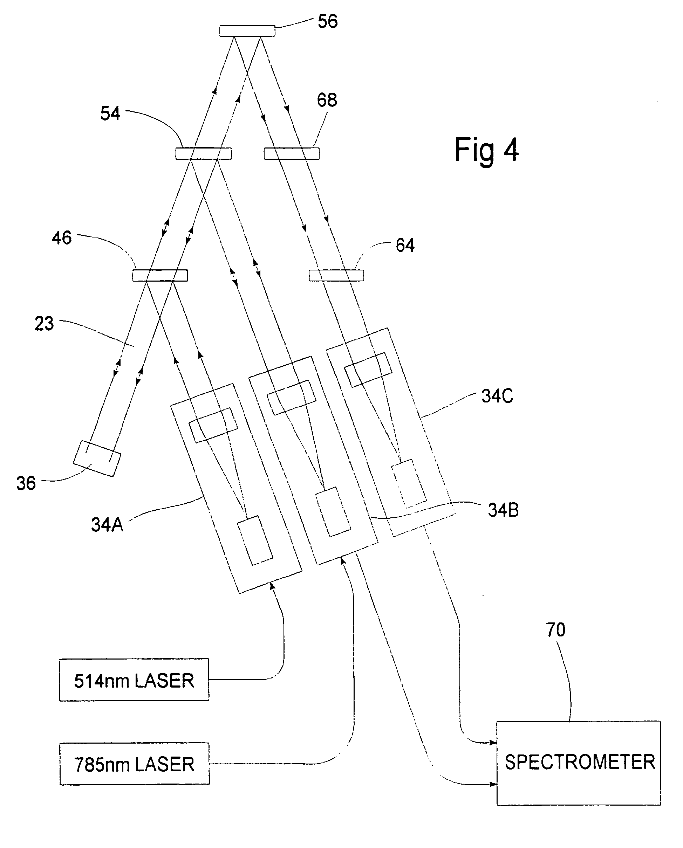

One problem of the system of Fig 3 is that the mirror 66 must be moved when changing from one operating mode to another. Although alignment of this mirror is not very difficult (since it does not affect the focusing of the laser beam) nevertheless it would be desirable to produce a system which does not require such adjustment by the user. An example of such a system is shown in Fig 4.

In Fig 4, the components are similar to those shown in Fig 3. They have therefore been given the same reference numerals and their description will not be repeated.

However, Fig 4 does not feature the movable mirror 66. Instead, the optical fibre connector 34B fulfils two different roles in the two different operating modes. When using the longer (785nm) excitation wavelength, it is fed to the optical fibre connector 34B as in Fig 3. However, when using the shorter (514nm) excitation wavelength via the optical fibre connector 34A, the filter 54 will reject photoluminescence and other inelastically scattered light at around 785nm. This passes to the optical fibre connector 34B.

In this mode, therefore, both the optical fibre connectors 34B and 34C are used for outputs from the system. They may be taken to separate spectroscopy and detection systems, and the results recombined in a computer which receives the outputs of both. Ideally, however, they are taken as two separate inputs to a Renishaw Mk III Raman System at 70. That system has the ability to receive multiple optical fibre inputs, and to disperse the respective spectra from these inputs at spaced positions on a common CCD detector. The outputs are then read from the CCD and again recombined within the computer. Alternatively they may be binned together on the CCD chip.

When recombining the signals, the computer can normalise them by multiplying them by an appropriate factor. This allows for the fact that the different signals have passed through different numbers of optical components and will therefore have suffered different amounts of attenuation. It also compensates for differences of intensity caused by the focusing of the light onto the optical fibres, and the optical fibre alignments.

For the laser inputs, we prefer to use single mode optical fibres connected to the connectors 34A,34B. This enables confocal operation, with the illuminated spot on the sample 16 being confocal with the ends of the delivery fibres. The output fibres connected to the connector 34C (and the connector 34B in Fig 4) may be single mode or multimode; multimode fibres are easier for broad band collection.

If desired, cathodoluminescence may be collected, without laser excitation, by connecting output optical fibres to all three of the fibre connectors 34A,B,C. In this case, the optical fibre connector 34A collects light rejected in the 514nm notch filter 46. Again, the signals may be recombined after separate detection, or in a Renishaw Mk III Raman System.

An advantage of both Fig 3 and Fig 4 is that the user does not need to replace and realign the holographic notch filters when changing laser excitation wavelength. He simply has to reconnect the optical fibre connectors 34A,B,C in the appropriate manner.

The arrangements of Figs 3 and 4 may of course be used separately from the electron microscope system shown in Fig 1. For example, the optical path 23 in Figs 3 and 4 may lead to a conventional optical microscope, in the manner shown in EP 543578. It may then be used for analysis of Raman, photoluminescence, etc light from a wide variety of samples. For example, in order to study Raman and photoluminescence from III-V semiconductor materials based upon gallium nitride, visible laser excitation may be provided via the connector 34B and UV laser excitation via the connector 34A, the holographic notch filters 46,54 being selected accordingly. Such materials are valuable because they are luminescent in the blue region of the spectrum, and the UV excitation enables study of their photoluminescence.

Other dichroic filters may be used in place of the holographic notch filters. For example, they may be edge filters or bandpass filters, and they may be dielectric or rugate filters instead of holographic.

Three or more excitation wavelengths may be made available, if desired, by providing one or more further optical fibre connectors. One or more further notch filters are placed in series with the optical path 23, in the same way as the filters 46,54, the notches of these further filters corresponding to the extra excitation wavelengths.

## Claims

1. An adapter arranged for performing an optical analysis of a sample (16) mounted in a sample chamber of another analytical apparatus (10), said analytical apparatus having an analytical axis (14) and projecting an analysis beam generally along said analytical axis towards a sample, **characterized in that** the adapter comprises:
a concave mirror (18) being located and having a form so as to receive an input light beam along an axis (24) generally transverse to said analytical axis, said mirror (18) for directing said input light beam generally along the analytical axis towards the sample, and for collecting the scattered light received from the sample and for directing said scattered light generally along the transverse axis,
wherein said mirror (18) is movable between an operative position on said analytical axis and an inoperative position away from said analytical axis.

2. An adapter according to claim 1, wherein an optical system (30) is provided for processing the input light beam and the scattered light, said optical system being movable together with the mirror as the mirror moves between the operative and inoperative positions.

3. An adapter according to claim 1 or claim 2, wherein an optical system (30) is provided for processing the input light beam and the scattered light, wherein the position of the mirror 18) is adjustable when it is in the operative position, and wherein the optical system is movable together with the mirror as it is adjusted.

4. An adapter according to claim 2 or claim 3, wherein the optical system includes one or more filters for rejecting light having the wavelength of the input light beam from said scattered light.

5. An adapter according to claim 2, claim 3 or claim 4, wherein the optical analysis is by spectroscopy, and the optical system is a light injection and rejection arrangement for the spectroscopy.

6. An adapter according to claim 4, wherein the optical system is a light injection and rejection arrangement for a spectroscopy system, for use with at least two different monochromatic light inputs, comprising:
an optical path (23) extending between a sample to be analysed and a spectroscopy system (70) for performing such analysis,
first and second inputs (34A, 34B) for receiving respective first and second excitation beams at respective first and second wavelengths,
a first filter (46) located in the optical path, at an angle such that it directs the first input beam towards the sample, and rejects elastically scattered light received from the sample while passing inelastically scattered light for analysis towards the spectroscopy system,
a second filter (54) located in the optical path, at an angle such that it directs the second input beam towards the sample, and rejects elastically scattered light received from the sample while passing inelastically scattered light for analysis towards the spectroscopy system,
light being received from the second filter (54) which has been rejected from the optical path'by the second filter when the sample is excited at the first wavelength, said light therefore representing desired inelastically scattered light, and
said rejected but desired inelastically scattered light either being recombined with other inelastically scattered light, or being detected separately.

7. An adapter according to any one of the preceding claims, wherein the mirror (18) is a paraboloid.

8. An adapter according to any preceding claim wherein the adapter includes a light source which provides said input light beam.

9. An adapter according to any preceding claim, wherein the adapter includes an optical analyser (30), wherein the scattered light collected and directed along the transverse axis by the mirror (18) is analysed by the optical analyser.

10. Optical analysis apparatus adapted for performing an optical analysis of a sample (16) mounted in a sample chamber of another analytical apparatus (10), said analytical apparatus having an analytical axis (14) and projecting an analysis beam generally along said analytical axis towards a sampler the optical analysis apparatus comprising:
a light source providing an input light beam;
an optical analyser (30);
a concave mirror (18) located so as to receive said input light beam along an optical axis (24), said mirror for directing said input light beam generally along the analytical axis towards the sample, and for collecting the scattered light received from the sample and for directing said scattered light generally along the optical axis to said optical analyser,
wherein said mirror is movable between an operative position on said analytical axis and an inoperative position away from said analytical axis.

## Patentansprüche

1. Adapter, der zur Ausführung einer optischen Analyse einer Probe (16) ausgebildet ist, die in einer Probenkammer einer anderen analytischen Vorrichtung (10) befestigt ist, wobei die analytische Vorrichtung eine analytische Achse (14) aufweist und einen Analysestrahl allgemein entlang der analytischen Achse in Richtung einer Probe projiziert, **dadurch gekennzeichnet, dass** der Adapter umfasst:
einen konkaven Spiegel (18), der so angeordnet ist und eine Form aufweist, um einen Eingangslichtstrahl entlang einer Achse (24) allgemein quer zu der analytischen Achse zu empfangen, wobei der Spiegel (18) zum Lenken des Eingangslichtstrahls allgemein entlang der analytischen Achse in Richtung der Probe und zum Sammeln des gestreuten Lichts, das von der Probe empfangen wird, und zum Lenken des gestreuten Lichts allgemein entlang der Querachse dient,
wobei der Spiegel (18) zwischen einer Betriebsposition an der analytischen Achse und einer Nichtbetriebsposition entfernt von der analytischen Achse bewegbar ist.

2. Adapter nach Anspruch 1, wobei ein optisches System (30) zur Verarbeitung des Eingangslichtstrahls und des gestreuten Lichts vorgesehen ist, wobei das optische System zusammen mit dem Spiegel bewegbar ist, wenn sich der Spiegel zwischen der Betriebs- und der Nichtbetriebsposition bewegt.

3. Adapter nach Anspruch 1 oder Anspruch 2, wobei ein optisches System (30) zur Verarbeitung des Eingangslichtstrahls und des gestreuten Lichts vorgesehen ist, wobei die Position des Spiegels (18) einstellbar ist, wenn er sich in der Betriebsposition befindet, und wobei das optische System zusammen mit dem Spiegel bewegbar ist, wenn er eingestellt wird.

4. Adapter nach Anspruch 2 oder Anspruch 3, wobei das optische System ein oder mehrere Filter zum Abweisen von Licht, das die Wellenlänge des Eingangslichtstrahls besitzt, von dem gestreuten Licht aufweist.

5. Adapter nach Anspruch 2, Anspruch 3 oder Anspruch 4, wobei die optische Analyse durch Spektroskopie erfolgt und das optische System eine Lichteinstrahl- und Abweisanordnung für die Spektroskopie ist.

6. Adapter nach Anspruch 4, wobei das optische System eine Lichteinstrahl- und Abweisanordnung für ein Spektroskopiesystem zur Verwendung mit zumindest zwei verschiedenen monochromatischen Lichteingängen ist, mit:
einem optischen Pfad (23), der sich zwischen einer zu analysierenden Probe und einem Spektroskopiesystem (70) zur Ausführung einer derartigen Analyse erstreckt,
einem ersten und zweiten Eingang (34A, 34B) zum Empfangen eines entsprechenden ersten und zweiten Erregungsstrahles mit einer entsprechenden ersten und zweiten Wellenlänge,
einem ersten Filter (46), der in dem optischen Pfad unter einem Winkel so angeordnet ist, dass er den ersten Eingangsstrahl in Richtung der Probe lenkt und elastisch gestreutes Licht, das von der Probe empfangen wird, abweist, während inelastisch gestreutes Licht zur Analyse in Richtung des Spektroskopiesystems durchgelassen wird,
einem zweiten Filter (54), der in dem optischen Pfad unter einem Winkel so angeordnet ist, dass er den zweiten Eingangsstrahl in Richtung der Probe lenkt und elastisch gestreutes Licht, das von der Probe empfangen wird, abweist, während inelastisch gestreutes Licht zur Analyse in Richtung des Spektroskopiesystems durchgelassen wird,
wobei Licht von dem zweiten Filter (54) empfangen wird, das von dem optischen Pfad durch den zweiten Filter abgewiesen worden ist, wenn die Probe mit der ersten Wellenlänge erregt ist, wobei das Licht daher gewünschtes inelastisch gestreutes Licht darstellt, und
das abgewiesene, jedoch gewünschte inelastisch gestreute Licht entweder mit anderem inelastisch gestreutem Licht rekombiniert oder separat detektiert wird.

7. Adapter nach einem der vorhergehenden Ansprüche, wobei der Spiegel (18) eine Paraboloid ist.

8. Adapter nach einem der vorhergehenden Ansprüche, wobei der Adapter eine Lichtquelle aufweist, die den Eingangslichtstrahl vorsieht.

9. Adapter nach einem der vorhergehenden Ansprüche, wobei der Adapter einen optischen Analysator (30) aufweist, wobei das gestreute Licht, das entlang der Querachse von dem Spiegel (18) gesammelt und gelenkt wird, von dem optischen Analysator analysiert wird.

10. Optische Analysevorrichtung, die zur Ausführung einer optischen Analyse einer Probe (16) ausgebildet ist, die in einer Probenkammer einer anderen analytischen Vorrichtung (10) befestigt ist, wobei die analytische Vorrichtung eine analytische Achse (14) aufweist und einen Analysestrahl allgemein entlang der analytischen Achse in Richtung einer Probe projiziert, wobei die optische Analysevorrichtung umfasst:
eine Lichtquelle, die einen Eingangslichtstrahl vorsieht;
einen optischen Analysator (30);
einen konkaven Spiegel (18), der so angeordnet ist, dass er den Eingangslichtstrahl entlang einer optischen Achse (24) empfängt, wobei der Spiegel zum Lenken des Eingangslichtstrahls allgemein entlang der analytischen Achse in Richtung der Probe und zum Sammeln des gestreuten Lichts, das von der Probe empfangen wird, und zum Lenken des gestreuten Lichts allgemein entlang der optischen Achse zu dem optischen Analysator dient,
wobei der Spiegel zwischen einer Betriebsposition an der analytischen Achse und einer Nichtbetriebsposition entfernt von der analytischen Achse bewegbar ist.

## Revendications

1. Adaptateur agencé pour effectuer une analyse optique d'un échantillon (16) monté dans une chambre d'échantillon d'un autre appareil analytique (10), ledit appareil analytique ayant un axe analytique (14) et projetant un faisceau d'analyse généralement le long dudit axe analytique vers un échantillon, **caractérisé en ce que** l'adaptateur comprend :
un miroir concave (18) positionné et formé de telle sorte à recevoir un faisceau de lumière d'entrée le long d'un axe (24) généralement transversal audit axe analytique, ledit miroir (18) étant destiné à diriger ledit faisceau de lumière d'entrée généralement le long de l'axe analytique vers l'échantillon, à collecter la lumière diffusée reçue de l'échantillon et à diriger ladite lumière diffusée généralement le long de l'axe transversal,
dans lequel ledit miroir (18) est mobile entre une position opérationnelle sur ledit axe analytique et une position non opérationnelle à l'écart dudit axe analytique.

2. Adaptateur selon la revendication 1, dans lequel un système optique (30) est prévu pour traiter le faisceau de lumière d'entrée et la lumière diffusée, ledit système optique étant mobile conjointement avec le miroir lorsque le miroir se déplace entre les positions opérationnelle et non opérationnelle.

3. Adaptateur selon la revendication 1 ou la revendication 2, dans lequel un système optique (30) est prévu pour traiter le faisceau de lumière d'entrée et la lumière diffusée, dans lequel la position du miroir (18) est ajustable lorsqu'il est dans la position opérationnelle, et dans lequel le système optique est mobile conjointement avec le miroir lorsqu'il est ajusté.

4. Adaptateur selon la revendication 2 ou la revendication 3, dans lequel le système optique comprend un ou plusieurs filtres pour rejeter la lumière ayant la longueur d'onde du faisceau de lumière d'entrée de ladite lumière diffusée.

5. Adaptateur selon la revendication 2, la revendication 3 ou la revendication 4, dans lequel l'analyse optique est effectuée par spectroscopie, et le système optique est un agencement d'injection et de réjection de lumière pour la spectroscopie.

6. Adaptateur selon la revendication 4, dans lequel le système optique est un agencement d'injection et de réjection de lumière pour un système de spectroscopie, destiné à être utilisé avec au moins deux entrées de lumière monochromatiques différentes, comprenant :
un trajet optique (23) s'étendant entre un échantillon devant être analysé et un système de spectroscopie (70) pour effectuer une telle analyse,
des première et seconde entrées (34A, 34B) pour recevoir des premier et second faisceaux d'excitation respectifs à des première et seconde longueurs d'onde respectives,
un premier filtre (46) situé dans le chemin optique, à un angle tel qu'il dirige le premier faisceau d'entrée vers l'échantillon, et rejette la lumière diffusée élastiquement de l'échantillon tout en laissant passer la lumière diffusée inélastiquement pour analyse vers le système de spectroscopie,
un second filtre (54) situé dans le trajet optique, à un angle tel qu'il dirige le second faisceau de lumière vers l'échantillon, et rejette la lumière diffusée élastiquement reçue de l'échantillon tout en laissant passer la lumière diffusée inélastiquement pour analyse vers le système de spectroscopie,
la lumière étant reçue du second filtre (54) qui a été rejetée du trajet optique par le second filtre lorsque l'échantillon est excité à la première longueur d'onde, ladite lumière représentant par conséquent la lumière diffusée inélastiquement souhaitée, et
ladite lumière rejetée mais diffusée inélastiquement souhaitée étant soit recombinée avec une autre lumière diffusée inélastiquement, soit détectée séparément.

7. Adaptateur selon l'une quelconque des revendications précédentes, dans lequel le miroir (18) est un paraboloïde.

8. Adaptateur selon l'une quelconque des revendications précédentes, dans lequel l'adaptateur comprend une source de lumière qui fournit ledit faisceau de lumière d'entrée.

9. Adaptateur selon l'une quelconque des revendications précédentes, dans lequel l'adaptateur comprend un analyseur optique (30), dans lequel la lumière diffusée collectée et dirigée le long de l'axe transversal par le miroir (18) est analysée par l'analyseur optique.

10. Appareil d'analyse optique adapté pour effectuer une analyse optique d'un échantillon (16) monté dans une chambre d'échantillon d'un autre appareil analytique (10), ledit appareil analytique ayant un axe analytique (14) et projetant un faisceau d'analyse généralement le long dudit axe analytique vers un échantillon, l'appareil d'analyse optique comprenant :
une source de lumière fournissant un faisceau de lumière d'entrée ;
un analyseur optique (30) ;
un miroir concave (18) positionné de sorte à recevoir ledit faisceau de lumière d'entrée le long d'un axe optique (24), ledit miroir étant destiné à diriger ledit faisceau de lumière d'entrée généralement le long de l'axe analytique vers l'échantillon, à collecter la lumière diffusée reçue de l'échantillon et à diriger ladite lumière diffusée généralement le long de l'axe optique vers ledit analyseur optique,
dans lequel ledit miroir est mobile entre une position opérationnelle sur ledit axe analytique et une position non opérationnelle à l'écart dudit axe analytique.
